(19) Europäisches Patentamt
European Patent Office
Office européen des brevets

(11) Publication number: **0 265 957**
**A2**

(12) # EUROPEAN PATENT APPLICATION

(21) Application number: **87115932.3**

(51) Int. Cl.⁴: **G03F 9/00**

(22) Date of filing: **29.10.87**

Claims 11 - 23 are deemed to be abandoned due to non-payment of the claims fees (Rule 31 (3) EPC).

A request for addition of pages 22 + 23 of the originally filed claims has been filed pursuant to Rule 88 EPC. A decision on the request will be taken during the proceedings before the Examining Division (Guidelines for Examination in the EPO, A-V, 2.2).

The application is published incomplete as filed (Article 93 (2) EPC). The point in the claim(s) at which the omission obviously occurs has been left blank.

(30) Priority: **31.10.86 JP 261521/86**

(43) Date of publication of application:
**04.05.88 Bulletin 88/18**

(84) Designated Contracting States:
**DE FR GB**

(71) Applicant: **DAINIPPON SCREEN MFG., CO., LTD.**
**1-1, Tenjinkitacho**
**Horikawadoriteranouchiagaru-4-chome**
**Kamikyo-ku Kyoto-shi Kyoto-fu(JP)**

(72) Inventor: **Murayama, Minoru**
**3-519 Grand Mezon Moriyama 300-15**
**Fuke-cho**
**Moriyama-shi Shiga(JP)**
Inventor: **Yamamoto, Takaharu**
**3-C K'S House 35 Arisugawa-cho Kawashima**
**Nishikyo-ku Kyoto(JP)**
Inventor: **Hashimoto, Takeji**
**1-98 Shibanosato**
**Nagaokakyo-shi Kyoto(JP)**

(74) Representative: **Goddar, Heinz J., Dr. et al**
**FORRESTER & BOEHMERT**
**Widenmayerstrasse 4/I**
**D-8000 München 22(DE)**

(54) **Apparatus for automatically providing positioning holes on film material.**

(57) Disclosed is an automatic mask cutting/drawing apparatus useful for purposes for both preparing a mask film including positioning holes and a desired image mask pattern and drawing a desired line image. The apparatus includes a table for receiving a film material thereon, a first carriage movable along the table surface in a first direction, a second carriage provided on the first carriage and movable along the first carriage in a second direction, first and second moving elements for respectively moving the first and second carriages in the respective directions, a drawing element provided on the second carriage and movable in the vertical direction relative to the film material for drawing a desired image pattern on the film material, and a cutter element provided adjacent to the drawing element and movable in the vertical direction relative to the film material for cutting it. Both the drawing element and cutter element are alternatively used as necessary.

EP 0 265 957 A2

Fig.1

60
12
76
62
74
72
58
56
54
44
42
38
34
32
II
II
46
68
26
28
66
24
64
16
18
16
10
22
20
14
36
40
70
48
4
50
52

# APPARATUS FOR AUTOMATICALLY PROVIDING POSITIONING HOLES ON FILM MATERIAL

## BACKGROUND OF THE INVENTION

The present invention relates generally to an apparatus for automatically providing positioning holes on a film material, and more particularly to an apparatus with a cutter unit for making a mask film and for forming positioning holes on a film material while moving the cutter unit in X-and Y-directions thereon.

It is well known that a so-called "pin-and-punch system" is used in a pre-press process. In the "pin-and-punch system", a pair of registering pins are provided on a predetermined position e.g. on an original holder of a process camera, where a film material, e.g. mask film having a desired opaque mask pattern, is mounted thereon together with an original to be masked. On the other hand, a pair of positioning holes engagable with the registering pins are provided both on the film material and on the original, by which the film material is precisely positioned on the original holder of the process camera, so that an undesired image of the original is masked by the mask film and that only a desired image thereof is exposed.

For the purpose of providing such positioning holes on a film material, several types of punching devices are supplied to the market. One of such conventional punching devices is shown in United States Patent No. 4,635,365 issued to Hashimoto et al.

Indeed the Hashimoto et al patent has an advantage for use in preparing positioning holes on a film material for a specific standard of the pin-and-punch system, but it is necessary to change a punching device when using a different standard of the pin-and-punch system.

In fact, several manufacturers adopt different standards in respect of such pin-and-punch systems, particularly in length between positioning holes and in diameter thereof, and they supply their apparatus to the market only adaptable for their own standards, consequently it is inconvenient for a large number of users to purchase and furnish the necessary number of punching devices adaptable for different standards of apparatus supplied by different manufacturers.

Moreover, the Hashimoto et al patent is directed to a preparation of relatively small sized film materials, where only one pair of positioning holes may ordinarily be provided along only one edge of the film material. As long as for such purpose, the Hashimoto et al patent may be most useful, but it will be almost difficult and troublesome, though not impossible, to provide positioning holes on a relatively large sized film material, where it is often necessary to provide positioning holes along respective four edges of the film material.

## SUMMARY OF THE INVENTION

Accordingly, it is a principal object of the present invention to provide a novel apparatus for use in preparation of positioning holes on a film material independent of any different standards of the pin-and-punch system.

It is another object of the invention to provide an apparatus for making a positioning hole on a film material of any size, and being capable of providing positioning holes along two or more edges of a film material.

It is a further object of the invention to provide a novel apparatus which can be used for both preparing a mask film for use in masking an undesired image on an original so as to expose only a desired image and providing positioning holes on the mask film.

The aforementioned objects are accomplished by the present invention, with an apparatus which includes a table for receiving a film material thereon, a first carriage movable along the table surface in a first direction; a second carriage movable along the first carriage in a second direction, first and second moving means for respectively moving the first and second carriages in respective directions, and cutter means provided on the second carriage for cutting the film material to form both a desired mask film and a desired positioning hole at a desired position on the film material, said cutter means being movable in the vertical direction relative to the film material and controllable to reach two different cutting depths in the film material.

Preferrably, the apparatus further comprises memory means for storing image pattern data including those concerning the positioning hole and those concerning a desired mask image pattern, and processing means for processing said image data and controlling the movements of the first and the second carriages in the first and the second directions and cutter means in the vertical direction relative to the film material.

In case of preparation of both the positioning holes and the mask film, the film material comprises an opaque layer for masking an undesired image and a transparent base layer for allowing a desired image pattern to be exposed.

The image pattern data concerning the positioning hole includes a discrimination command for cutting both the opaque and transparent layers, coordinate values of the positioning hole and a function command for representing a cutting figure, e.g. line, arc, ellipse, circle or the like.

The image pattern data concerning the desired mask image pattern includes a discrimination command for cutting only the opaque layer of a desired mask image pattern, coordinate values of the desired mask image pattern and a function command for representing a cutting figure, e.g. line, arc, ellipse, circle or the like.

Preferrably, the apparatus further comprises drawing means provided adjacent to said cutter means for drawing a desired image pattern on the film material. When using the drawing means, the film material comprises a drawing sheet adaptable for drawing a desired image pattern by the drawing means.

According to a preferred embodiment of the present invention, the apparatus is equipped with both the drawing means and the cutter means for both purposes of image drawing and mask cutting, which are alternatively used to carry out either one of the purposes.

It is preferable that the cutter means comprises a cutter blade for cutting the film material, a supporting member for holding said cutter blade at the lowermost part thereof, rotation means for rotating said supporting member so as to turn the cutter blade to a desired cutting direction, and moving means for moving said cutter blade in the vertical direction relative to the film material, said moving means being controllable so that the cutter blade reaches different cutting depths in the film material.

In accordance with a preferred embodiment, the moving means comprises biasing means provided on the supporting member for biasing the supporting member upward so as to raise the cutter blade from the film material, and linear motor means for moving the cutter blade downward up to different cutting depths in response to electricity applied thereto.

Having the aforementioned features, the present invention has the following useful advantages:

The apparatus according to the present invention makes it possible to prepare the positioning holes at a desired position on the film material independent of different standards of the pin-and-punch system.

The apparatus can be used for purposes of both preparing a mask film and making positioning holes adaptable for any different standards of the pin-and-punch system.

The apparatus can also be used as an automatic drawing apparatus for drawing a desired image pattern on a drawing sheet material.

Other novel features and advantages of the present invention will become apparent in the course of the following detailed description taken together with the accompanying drawings, which are directed only to the understanding of the present invention and not to the restriction of the scope of the invention.

## BRIEF DESCRIPTION OF THE DRAWINGS

Figure 1 is a vertical sectional view of a cutter unit;

Figure 2 is a fragmentary sectional view along the line II-II of Figure 1;

Figures 3 and 4 are an elevational view and a side view, showing a cutter blade to be mounted to the cutter unit;

Figures 5 and 6 are a fragmentary sectional view, respectively, showing the preparation of a mask film;

Figure 7 is a plane view of an original to be masked;

Figure 8 is a plane view of a mask film to be superposed on the original;

Figure 9 is a perspective view of an apparatus to which the cutter unit is mounted;

Figure 10 is an enlarged perspective view showing an outline of a cutter unit and a drawing drawing unit;

Figure 11 is a fragmentary perspective view showing the cutter unit in more detail; and

Figure 12 is a fragmentary perspective view showing a part of the drawing unit.

## DETAILED DESCRIPTION OF THE PREFERRED EMBODIMENTS

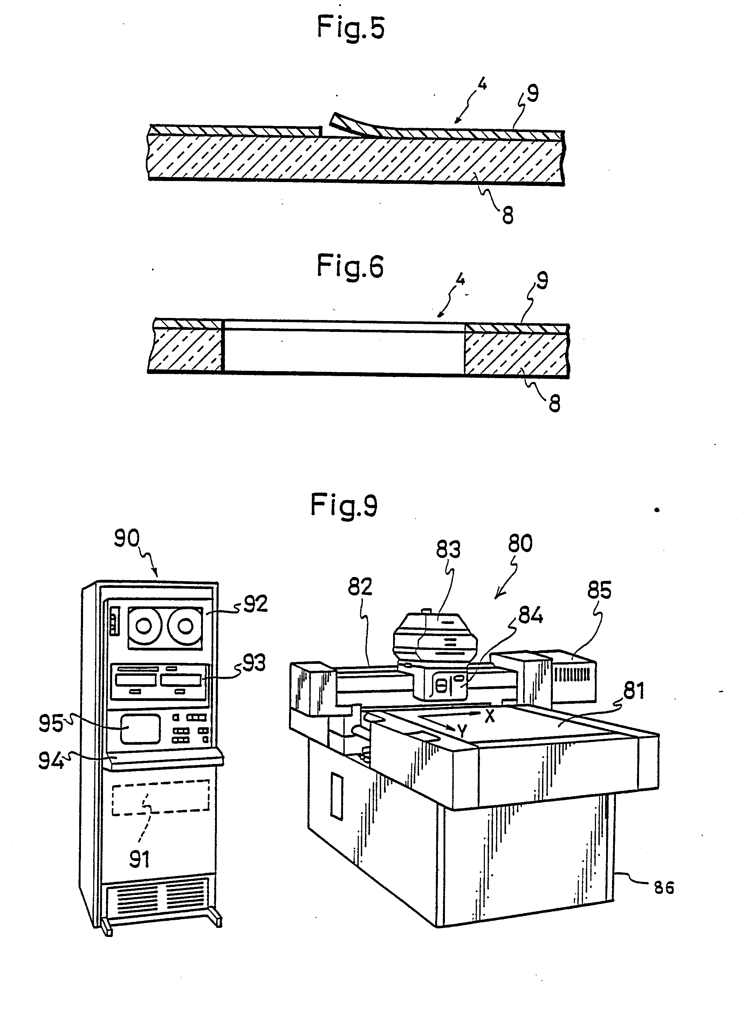

Referring to Figure 9, which shows an outline of an apparatus according to the present invention, the apparatus generally comprises a work unit 80 and a console unit 90. The console unit 90 includes a magnetic tape device 92, a floppy disc device 93, a key board 94 provided with a number of function keys and ten keys thereon, a monitoring unit 95 and a computer unit 91. Image information to be cut or drawn and control instructions are stored either in the magnetic tape or in a floppy disc, in the form of digital signals. Additional control instructions for work unit 80 are inputted through the key board. The computer unit 91 provided in the console unit 90 processes the image information on the basis of the control instructions, to output necessary control signals to the work unit 80.

Selection which of the magnetic tape or floppy disc should be used is determined on the basis of quantity of information to be stored. That is, when a large quantity of mask information and control instruction is to be stored, the magnetic tape is selected, and to the contrary, when a relatively small quantity thereof, e.g. to the extent of one megabyte, is to be stored, the floppy disc is selected.

The work unit 80 is electrically connected with the console unit 90 and is controlled by the output signals from the computer unit 91.

The work unit 80 comprises a base frame 86, a drawing/cutting table 81 placed on the base frame, a first carriage 82 slidably movable along the table surface in the Y-direction, a second carriage 83 slidably movable along the first carriage in the X-direction, and a receiving station 84 to which both a cutter unit 10 and a drawing pen holder 101 is mounted.

The carriages 82 and 83 is driven by motors (not shown) contained within the table 81 and a housing 85, respectively. The motors are controlled by the signals outputted from the computer unit 91, by which the receiving station 84 is moved in the X-and Y-directions, so that a desired image pattern is traced on the film material either by a cutter blade on the cutter unit 10 or by a drawing pen on the drawing pen holder 101.

The table 81 includes suction elements (not shown) for fixedly holding a film material, e.g. a drafting paper, a mask film or the like, on the upper surface thereof.

To the respective motors for driving the carriages 82 and 83, a rotary encoder (not shown) is provided, by which a travel quantity of the respective carriages in the X-and Y-directions is measured to output to the computer unit 91, respectively.

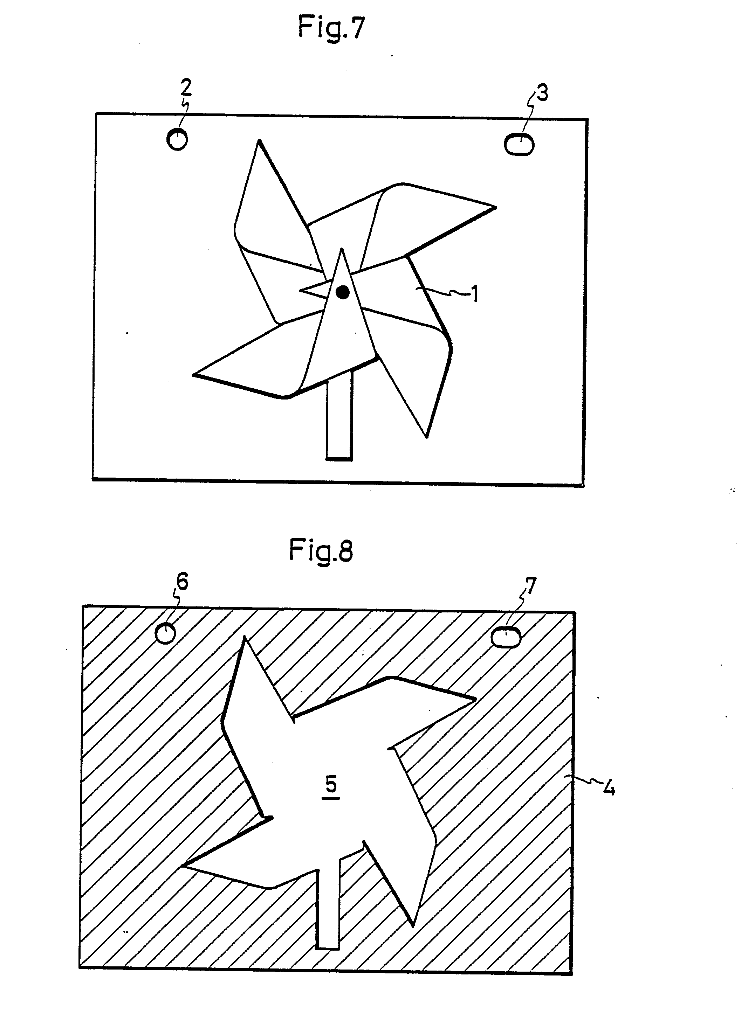

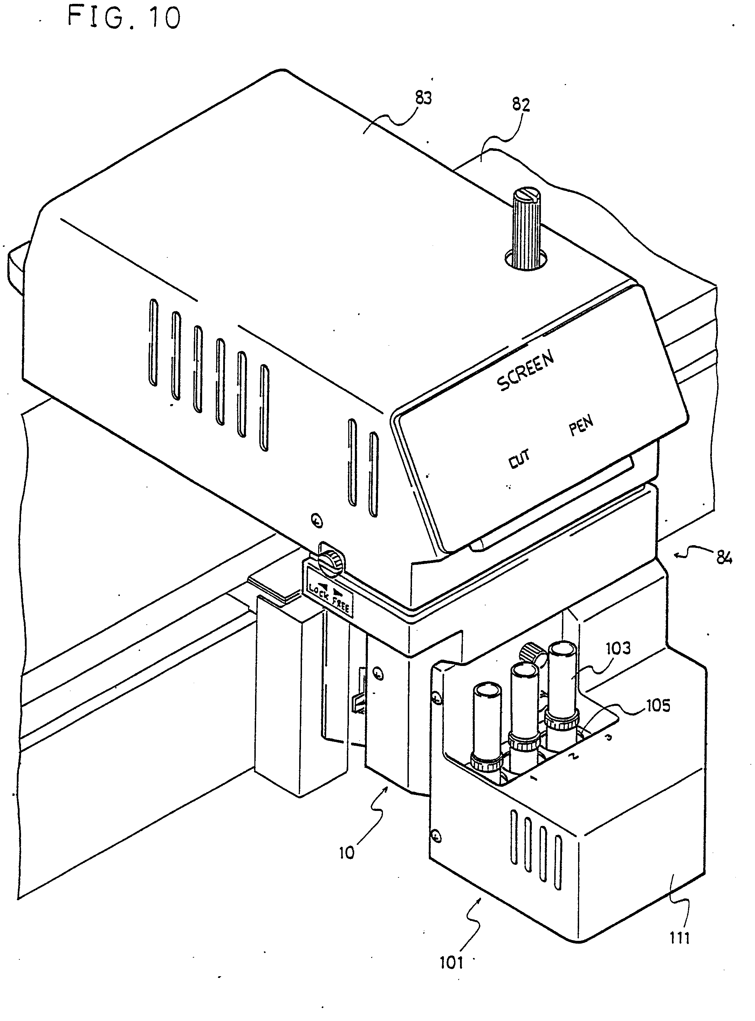

Referring to Figure 10, which shows an enlarged perspective view of the cutter unit 10 and the drawing unit 101, both the cutter unit and the drawing unit are fixedly mounted to the receiving station 84 of the second carriage 83. The cutter unit 10 includes a cutter blade provided at the lowermost part thereof, and the drawing unit 101 includes drawing pens thereon, both of the cutter blade and drawing pens are movable in the vertical direction relative to the upper surface of the film material, on which detailed discussions are given herebelow.

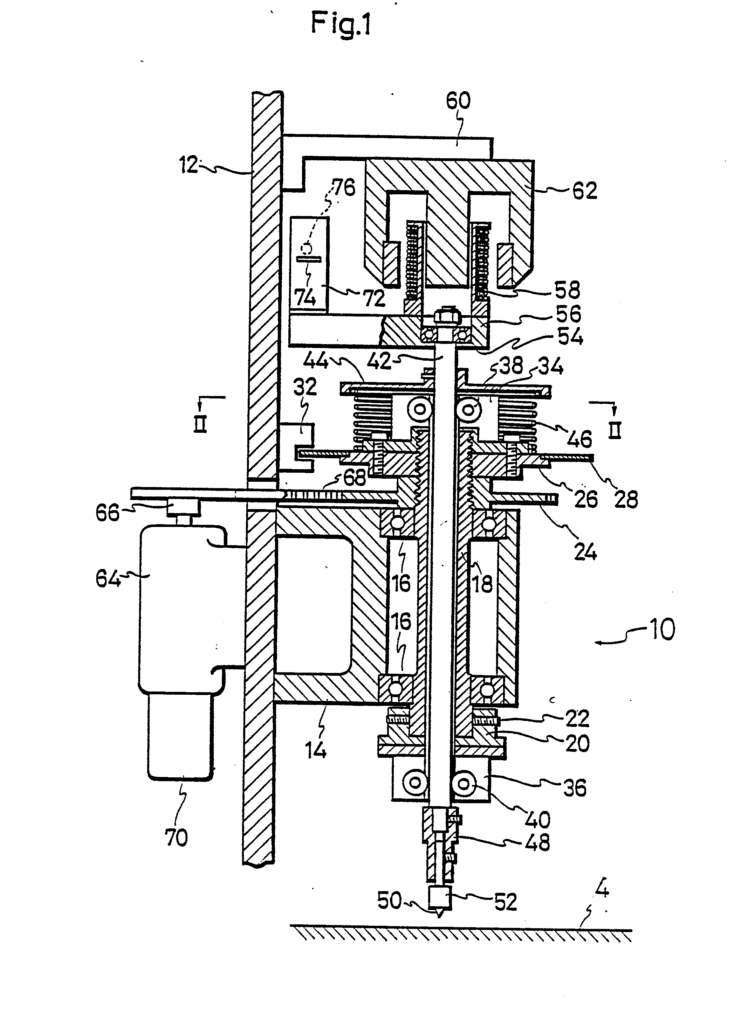

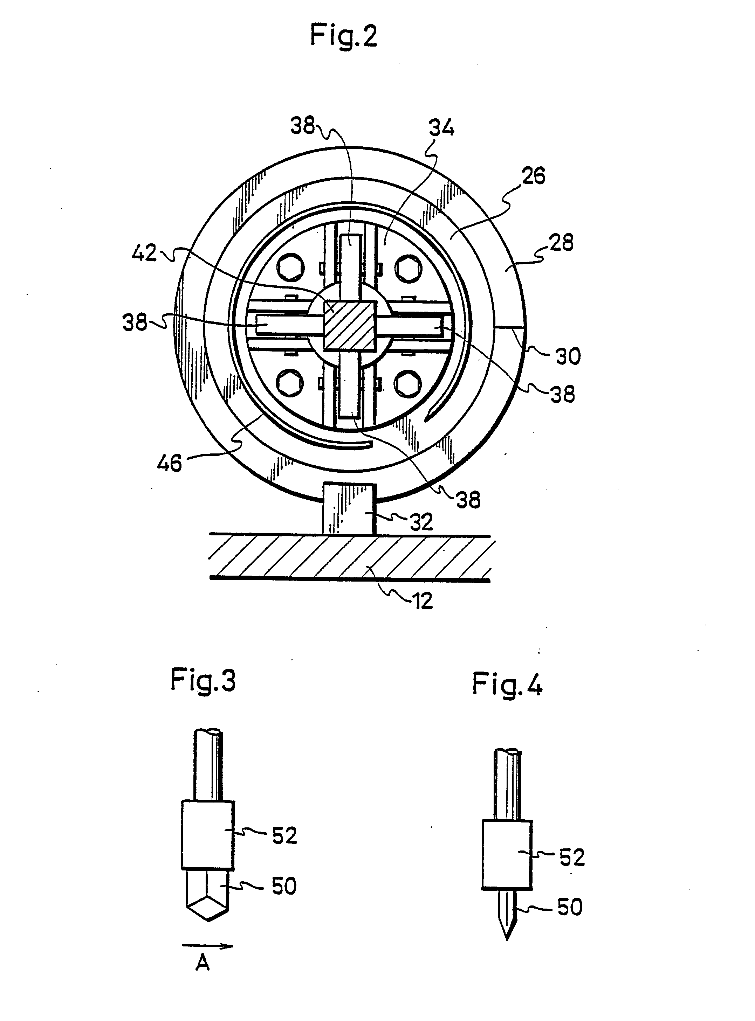

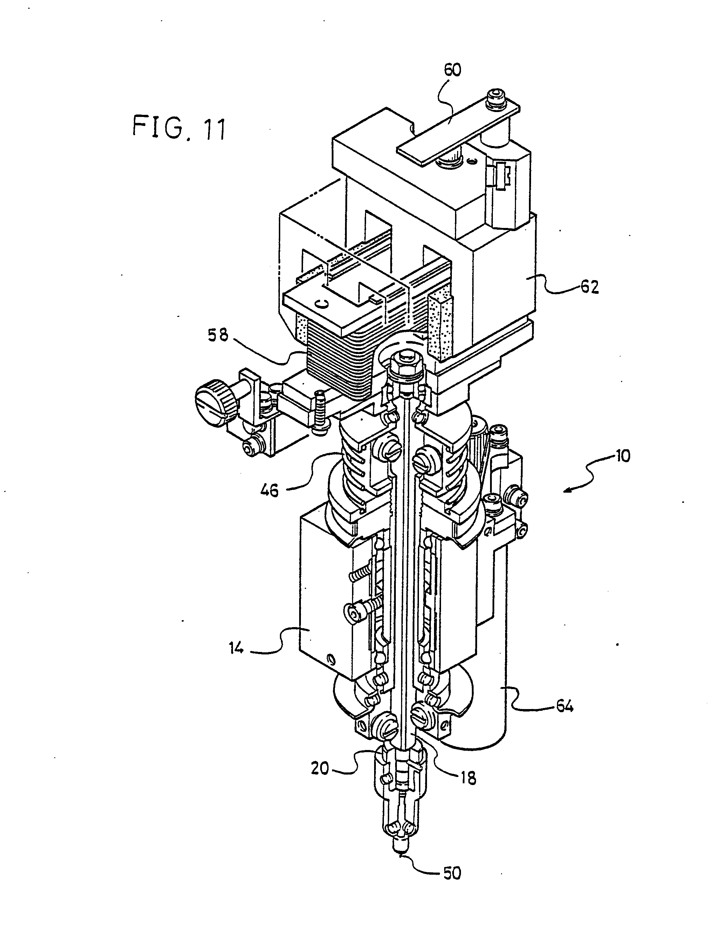

Referring to Figures 1 and 2 together with Figure 11, which show a structure of the cutter unit 10 in more detail, there provided is a mask film 4 which is fixedly mounted on the table 81 by the suction element. The cutter unit 10 is provided in such a manner as to be able to travel along the X- and Y-directions, by means of the carriages 82 and 83.

The cutter unit 10 is mounted on the receiving station 84 which includes a supporting member 12. Also, a drawing unit 101 is mounted adjacent to the cutter unit 10 for carrying different drawing pens, e.g. a hollow pen, a ball point pen, a scriber or the like, for different purposes, but the drawing of the drawing unit 101 is omitted in Figures 1 and 2.

The supporting member 12 is provided with a bracket 14 having bearings 16 through which a hollow shaft 18 is rotatably supported. The hollow shaft 18 has a flange 20 fixed to its lower end portion by means of screws 22, and has a gear 24 and a disc 26 at its upper end portion, which function as a double nut. The disc 24 and flange 20 define the displacement of the hollow shaft 18 with respect to the bracket 14.

The disc 26 is provided with a ring-shaped index rotor 28 at its periphery, which is to measure an origin for controlling the rotation of the hollow shaft 18. The index rotor 28 has an index line 30 drawn thereon, as shown typically in Figure 2. When the index line 30 passes through a detector 32 fixed to the supporting member 12, it is measured so that a starting point is determined for counting the number of pulses outputted from a rotary encoder 70 attached to a motor 64 for rotating the hollow shaft 18.

The reference numerals 34 and 36 denote an upper bearing and a lower bearing fixed to the disc 26 and the flange 20, respectively. As shown in Figure 2, the upper bearing 34 is provided with four roller carriers in a crosslike state on which rollers 38 are carried. Likewise the lower bearing 38 is provided with rollers 40 in the same manner. The rollers 38 and 40 support a main shaft 42 extending through the hollow shaft 18 in such a manner as to be vertically movable along the inside wall thereof and rotate in accordance with the rotation thereof.

The reference numeral 46 denotes a spring provided between a disc plates 44 and 26 in such a manner as to bias the main shaft 42 and the disc plate 44 upward. The main shaft 42 is provided with a cutter holder 52 having a cutter blade 50 through a socket 48 at its lower terminating end, and is rotatably connected to a plate member 56 through a bearing 54, which the plate member is caused to move up and down in the manner described above. Preferably the bearing 54 comprises a self-aligning type.

The plate member 56 is provided with an actuator 58, which is opposed to a core 62 fixed to a bracket 60 projecting from the supporting member 12. When voltage is impressed, the actuator 58 is biased downward, wherein the biasing power is controlled by adjusting the applied voltage. Hereinafter, the unitary assembly of the core 62 and actuator 58 will be referred to as linear motor.

The motor 64 for rotation of the cutter blade is provided in place on the supporting member 12, and the driving shaft thereof is provided with a gear 66, to which the gear 24 of the hollow shaft 18 is connected through a timing belt 68. In such a way, the hollow shaft 18 (accordingly, the main shaft 42) is rotated by the motor 64 by means of the timing belt.

As referred to above, the motor 64 is provided with the rotary encoder 70, which outputs a number of pulses in proportion to the rotations thereof so as to control the rotation of the motor 64 by reference to the starting point decided by measuring the index line 30 on the index rotor 28 which passes through the detector 32. In this way, the cutter blade 50 is caused to manipulate as desired.

The plate member 56 is provided with a position detecting device for detecting the position taken by the main shaft 42 with respect to the mask film 4 so as to control the speed at which the main shaft 42 descends. The position detecting device comprises a slitted plate 72 including a slit 74 and extending upward from plate member 56, and a set of a light source and an optical receiptor 76. The slit 74 is located so as to come into alignment with the optical axis of the set of the light source and receiptor 76 when the cutter blade descends up to a point immediately above the mask film 4 placed on the table. In this case, the position detecting device outputs a signal, thereby slowing down the descending speed of the cutter blade 50. This allows the cutter blade 50 to come into contact with the mask film 4 at a safe speed. Until then, the cutter blade 50 is caused to descend at a relatively high speed by increasing the voltage applied to the core 62, since, if the cutter blade 50 descends over all the distance at a slow speed, the operation will take inefficiently long.

The cutter blade 50 is made of hard material such as diamond, and is shaped as shown in Figures 3 and 4, wherein Figure 3 shows a front view in the moving direction A, and Figure 4 shows a side view thereof. When the mask film is placed on the table 10, a cutting mat e.g. of soft vinyle chloride (not shown) is preferably laid under the mask film so as to keep the edge of the cutter blade 50 away from the surface of the table 10. The mask film is fastened to the cutting mat by means of an appropriate measure, e.g. a suc tion element or an adhesive tape.

It is determined which of the cutter blade 50 and the drawing pen is used by instructions inputted through the keyboard 94. That is, if an image pattern drawing such as a block copy is intended, instructions for an image pattern drawing are inputted through the key board 94, and a drawing pen is actuated for drawing a desired image pattern on the basis of the image information stored either in the magnetic tape or in the disc floppy. If a mask cutting for a mask film is desired, instructions for mask cutting are inputted through the key board, and in response to the instructions the cutter unit is actuated for cutting a desired mask pattern thereon.

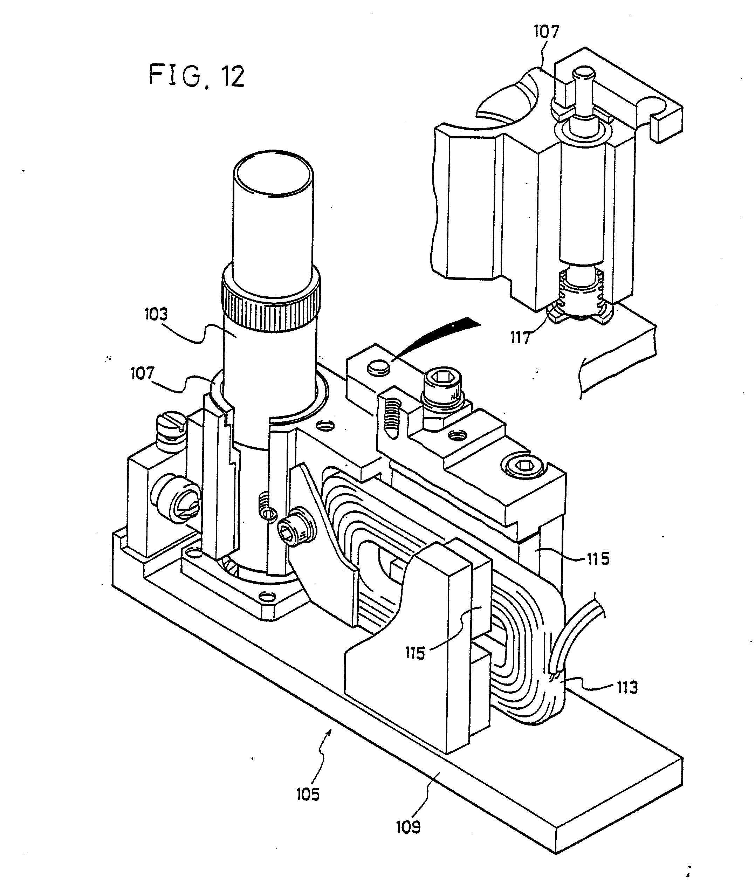

Referring to Figures 10 and 12, which show the drawing unit 101 in more detail, the drawing unit 101 is mounted in front of the cutter unit 10. The drawing unit 101 includes three sets of pen station 105, to which desired drawing pens 103 are mounted as necessary.

Each pen station 105 comprises a housing 111, bracket 109 fixedly mounted in the housing, a holder 107 movably provided on the bracket for holding a drawing pen 103 vertically thereon and a linear motor having substantially the same structure as that in the cutter unit.

The linear motor comprises an actuator 113 and a core 115 which is opposed the actuator. Similarly to that in the cutter unit 10, the actuator 113 is biased downward, when voltage is impressed, wherein the biasing power thereof is controlled by adjusting the voltage applied thereto.

The holder 107 is normally biased upward by means of a spring 117 provided thereto, so as to raise a drawing pen 103 from a film material when it rests.

Referring to Figures 5 and 6, the mask film 4 comprises a transparent substratum 8 and an opaque peeling layer 9, which the peeling layer of a desired image pattern is cut along its profile and peeled therefrom. Such a mask film as above is commercially supplied as "CADPEEL" by Dainippon Screen Mfg. Co., Ltd.

When cutting a desired mask image pattern, the cutter blade 50 may penetrate slightly into the substratum 8 beyond the opaque peeling layer 50, as shown in Figure 5. Figure 6 shows the mask film 4 having a positioning hole in which a registering pin fits. In this case, the depth of the cut is controlled by increasing the voltage applied to the linear motor. More particularly, when only the opaque peeling layer of a desired image pattern is cut out of the mask film, the voltage is adjusted to be relatively low, thereby causing the cutter blade 50 to touch the mask film softly to the extent that it penetrates into the peeling layer 9 but does not deeply penetrate into the transparent substratum 8. To the contrary, when the positioning hole is to be made, relatively high voltage is impressed to the linear motor so as to enable the cutter blade 50 to penetrate through the substratum 8. The piercing of the positioning holes can be carried out before, after or during the cutting of the desired image patterns in the peeling layer.

The applied voltage is previously determined in accordance with the characteristics of the linear motor, the weight of the cutter unit, the strength of the biasing spring 46 and the quality of the mask film so as to secure an adequate pressure with which the cutter blade 50 touches the mask film. An experiment has demonstrated that, when the peeling layer 9 alone was cut, an adequate pressure was 20gf, and when both the substratum 8 and the peeling layer 9 were cut, an adequate pressure was in a range of 120 to 300gf.

Control of the depth of cut may, of course, be done by adjusting amperage applied either to the linear motor of the cutting unit or to that of the drawing unit. Preferrably, the control is done by adjusting both the voltage and the amperage applied thereto.

In operation, the cutter unit 10 is caused to move so as to enable the cutter blade 50 to manipulate along the outline of the desired image pattern, during which the cutter blade 50 is rotated in a direction corresponding to a moving direction of the cutter unit 10 by controlling the motor 64.

When the peeling layer of the desired mask pattern is cut out of the mask film, adjustment of both voltage and amperage is effected to the linear motor so that the cutter blade 50 penetrates into the peeling layer 9 alone, not into the substratum 8. When the positioning holes are made for the registering pins, a high voltage is applied so as to enable the cutter blade 50 to penetrate into the substratum 8. After all the desired cuts are made, the peeling layer of the desired mask pattern whose outline was cut is removed therefrom, thereby allowing the substratum 8 in the image pattern area to expose itself as shown in Figure 6. In such a manner as above, a desired mask film both with the positioning holes and with the desired mask pattern is obtained. Both the mask pattern and the positioning holes are cut by the same cutter blade 50 of a single apparatus on only one process by adjusting voltage and/or amperage applied to the linear motor. This secures the precise relative positioning between the desired mask patterns and positioning holes on the mask film, and accordingly, when the mask film is superposed on an original to be masked, the precise positioning relative to the original is secured.

Now, operations for obtaining a desired mask film will be discussed herebelow. First, a block copy or negative film is placed on an appropriate coordinate apparatus (hereinafter referred to merely as digitizer), e.g. "Backlighting Digitizer FG-II BL" manufactured by Dainippon Screen Mfg. Co., Ltd., by which the desired image pattern information is obtained and stored either in the magnetic tape or in the floppy disc as necessary.

The image pattern information involves one concerning the positioning holes and one concerning the mask image pattern. When the image pattern information concerning positioning holes is inputted, a "positioning hole cutting command" is inputted, and then coordinate values of the desired positioning holes are measured on the digitizer, and function commands for desired positioning holes, which represent line, arc, ellipse, circle, or the like, are selected from a menue table thereon. These commands and coordinated values are stored either in the magnetic tape or in the floppy disc.

When the image pattern information concerning mask image patterns is inputted, a "cut-mask command" is inputted, and then coordinate values of the desired mask image pattern of the block copy or negative film are measured on the digitizer, and function commands as mentioned above are selected. These commands and coordinate values are also stored either in the magnetic tape or in the floppy disc.

Next, a film material, e.g. mask film "CADPEEL" or drawing sheet, is placed on the work table 81, which is fixedly held thereon by means of a suction element. Then aforementioned image pattern data are processed by the computer unit 91 of the console unit 90. In response to the "positioning hole command", the computer unit 91 outputs a control signal for controlling an offset pressure of the cutter unit 10 against the film material 4. As mentioned above, the offset pressure is controlled, e.g. at 200 gf. While, in response to the "mask-cut command", the computer unit outputs a control signal for controlling an offset pressure of the cutter blade, e.g. at 20 gf.

Further, in response to the coordinate values and the function commands, the computer unit 91 outputs control signals for controlling the direction of the cutter blade 50 on the cutter unit as well as the movement of the cutter unit in the X-and Y-directions.

In such a way as above, the desired positioning holes and mask image patterns are cut by the cutter blade. An operator removes the thus cut area of the positioning holes and peels the opaque layer corresponding to the desired image pattern, whereby a desired mask film as shown in Figure 8 is obtained. In Figure 8, a hatched area denotes an opaque one, by which undesired images of the original are masked. A reference numeral 5 denotes a transparent area, where the opaque layer is peeled from the film material, which precisely corresponds to the outer contour of the desired image to be exposed as shown in Figure 7 and through which only the desired image is exposed on a photosensitive material, e.g. placed on a focal plane of a process camera.

A reference numerals 6 and 7 denote positioning holes having a different shape from each other, where both the opaque layer and the transparent layer are removed to fit the registering pins thereinto. The left positioning hole 6 is formed into a circle which precisely corresponding to the shape of the corresponding registering pin. The right positioning pin 7 is formed into a slot extending along the adjacent edge of the film material, by which fitting of the corresponding registering pin thereinto is easily carried out.

As can be apparently understood, the positioning holes can be formed any position on the film material so as to be adaptable for any specific pin-and-punch system.

When using the mask film thus obtained, first an original to be reproduced is positioned, e.g. on an original holder of a process camera, by fitting the registering pins fixed on the holder into the positioning holes provided on the original. One can use "CP-COLOR" model CP-4850 supplied from Mitsubishi Paper Mills Ltd. as such a process camera as mentioned above.

Then, the mask film thus obtained is superposed onto the original by fitting the registering pins into the positioning holes thereof in the same manner as above. Both the original and the mask film are closely pressed against the original holder, e.g. by a transparent pressure plate, by which only the desired image 1 on the original is reproduced on a photosensitive material placed on the focal plane of the camera.

Now, operations for drawing a desired image pattern on a film material will be discussed herebelow. First, an original or a rough sketch of a desired image is placed on a digitizer. An operator inputs desired coordinate values of the image and appropriate function commands which represent appropriate line figures, e.g. line, arc, ellipse, circle or the like, by simulating the image on an appropriate monitoring device. A selection commands for designating an appropriate drawing pen among those held on the drawing unit are also inputted in accordance with a purpose of line drawing. The image pattern data thus inputted is stored either in the magnetic tape or in the floppy disc.

Next, an appropriate drawing sheet is placed on the work table 81, which is fixedly held thereon by means of a suction element. The aforementioned image pattern data are processed by the computer unit 91 of the console unit 90. In response to the selection command, the computer unit outputs a designating signal for designating an appropriate drawing pen and a control signal for controlling an offset pressure and travelling speed in X-and Y-directions adaptable for thus designated drawing pen.

On the basis of the output signals, the drawing pen is controlled, to draw a desired image on the drawing sheet.

Although discussions on the drawing unit 105 and operations for drawing a desired image pattern are not given in detail, discussions on the cutter unit and operations for cutting a desired image pattern are applicable to those as long as appropriate. Accordingly, a person skilled in the art can easily understand how to make and use the apparatus according to the invention.

Without further analysis, the foregoing will so fully reveal the gist of the present invention that others can, by applying current knowledge, readily adapt it for various applications without omitting features that, from the standpoint of prior art, fairly constitute essential characteristics of the generic or specific aspects of this invention.

What is claimed as new and desired to be protected by letters patent is set forth in the appended claims.

The features disclosed in the foregoing description, in the claims and/or in the accompanying drawings may, both separately and in any combination thereof, be material for realising the invention in diverse forms thereof.

**Claims**

1. An apparatus for automatically forming both a mask film and a positioning hole on a film material comprising:

a table for receiving the film material thereon;

a first carriage movable along the table surface in a first direction;

a second carriage movable along the first carriage in a second direction;

first and second moving means for respectively moving the first and second carriages in the respective directions; and

cutter means provided on the second carriage for cutting the film material to form both a desired mask film and a desired positioning hole at a desired position on the film material, said cutter means being movable in the vertical direction relative to the film material and controllable to reach two different cutting depths in the film material.

2. An apparatus as set forth in claim 1, further comprising memory means for storing image pattern data including those concerning the positioning hole and those concerning a desired mask image pattern; and processing means for processing said image data and controlling the movements of the first and the second carriages in the first and the second directions and cutter means in the vertical direction relative to the film material.

linear motor means is controllable in accordance with electricity applied thereto.

12. An apparatus as set forth in claim 1, 9 or 10, further comprising position detector means for detecting a position to which the cutter blade comes immediately before the cutter blade contacts with an upper surface of the film material,

wherein said position detector means includes a slitted plate having a slit thereon and extending in the vertical direction relative to the film material, said slit being provided at the predetermined position of the plate corresponding to a position to which the cutter blade comes immediately before the contact with the film material; and

a pair of a light source and a light receiving element, which are disposed opposite sides of the slitted plate, and when the slit comes between the light source and the light receiving element, a signal is outputted therefrom so as to slowing down the descending speed of the cutter blade by adjusting electricity applied to the linear motor means.

13. An apparatus as set forth in claim 9, wherein said rotation means includes:

a motor having a rotary shaft for rotating the supporting member by a desired angle;

transmitting means for transmitting the driving force of the motor to the supporting member;

a rotary encoder disposed on the rotary shaft of said motor;

an index rotor provided on the supporting member and having an index line drawn thereon for rotating together with the supporting member;

an index detector provided opposite to said index rotor for measuring the angle of the cutter blade; said index detector being electrically connected with computer means to output a position signal, on the basis of which the motor is controlled so as to turn the cutter blade to a desired cutting direction.

14. An automatic drawing apparatus with a cutter unit for automatically drawing an image on the film material comprising:

a table for receiving the film material thereon;

a first carriage movable along the table surface in a first direction;

a second carriage movable along the first carriage in a second direction;

first and second moving means for respectively moving the first and second carriages in the respective directions;

drawing means provided on the second carriage and movable in the vertical direction relative to the film material for drawing a desired image on the film material; and

cutter means provided adjacent to said drawing means and movable in the vertical direction relative to the film material to reach two different cutting depths in the film material, both said drawing means and said cutter means being alternatively used as necessary.

15. An apparatus as set forth in claim 14, further comprising memory means for storing image pattern data including those concerning a line drawing and those concerning a film cutting; and processing means for processing said image data and for controlling the movements of the first and second carriages and either of said drawing means or said cutter means respectively in the first, the second and the vertical directions.

16. An apparatus as set forth in claim 15, wherein the image data concerning a line drawing includes a pressure command to be applied to the drawing means, coordinate values of the line image and a function command for representing a drawing figure.

17. An apparatus as set forth in claim 15, wherein the image data concerning film cutting includes a discrimination command for cutting the film material in deep or in shallow, coordinate values of a contour image to be cut and a function command for representing a cutting figure.

18. An apparatus as set forth in claim 14, wherein said film material comprises a drawing sheet adaptable for drawing a desired line image by said drawing means.

19. An apparatus as set forth in claim 14, wherein said film material comprises an opaque layer for masking an undesired image and a transparent base layer for allowing a desired image pattern to be exposed.

20. An apparatus as set forth in claim 14, wherein said drawing means comprises:

a holder provided on the second carriage for holding a drawing pen to be used thereon;

a drawing pen adaptable for desired line drawing; and

moving means for moving said drawing pen in the vertical direction relative to the film material, said moving means being movable between a first position where the drawing pen is apart from the film material to rest thereat and a second position where the same is in contact with the film material to draw thereon.

21. An apparatus as set forth in claim 14, wherein said cutter means comprises:

a cutter blade for cutting the film material;

a supporting member for holding said cutter blade at the lowermost part thereof;

rotation means for rotating said supporting member so as to turn the cutter blade to a desired cutting direction; and

moving means for moving said cutter blade in the vertical direction relative to the film material, said moving means being controllable so that the cutter blade reaches different cutting depths in the film material.

22. An apparatus as set forth in claim 21, wherein said moving means comprises:

biasing means provided on the supporting member for biasing the supporting member upward so as to raise the cutter blade from the film material; and

linear motor means for moving the cutter blade downward up to different cutting depths in accordance with electricity applied thereto.

23. An apparatus as set forth in claim 14 or 21, further comprising position detector means for detecting a position to which the cutter blade comes immediately before the cutter blade contacts with an upper surface of the film material,

wherein said position detector means includes a slitted plate having a slit thereon and extending in the vertical direction relative to the film material, said slit being provided at the predetermined position on the plate corresponding to a position to which the cutter blade comes immediately before the contact with the film material; and

a pair of a light source and a light receiving element, which are disposed opposite sides of the slitted plate, and when the slit comes between the light source and the light receiving element, a signal is outputted therefrom so as to slowing down the descending speed of the cutter blade by adjusting electricity applied to the linear motor means.

Fig.1

60
12
76
62
74
72
58
56
54
44
42
38
34
32
II
46
II
68
26
28
66
24
64
16
18
16
10
22
14
20
36
70
40
48
4
50
52

Fig.2

38
34
26
28
42
38
30
38
46
38
32
12

Fig.3

52
50
A

Fig.4

52
50

Fig.5

4
9
8
4
9
8

Fig.6

Fig.9

90
92
93
95
94
91
83
80
82
84
85
81
X
Y
86

Fig.7

2
3
1

Fig.8

6
7
5
4

FIG. 10

83
82
SCREEN
PEN
CUT
LOCK FREE
84
103
105
1
2
3
10
101
111

FIG. 11
60
62
58
10
46
14
64
20
18
50

107
103
107
117
115
115
113
105
109

FIG. 12

# FORRESTER & BOEHMERT

Professional Representation at the European Patent Office Zugelassen zur Vertretung vor dem Europäischen Patentamt

Forrester & Boehmert, Widenmayerstrasse 4 D-8000 München 22

European Patent Office
Erhardtstr. 27

8000 München 2

WIDENMAYERSTRASSE 4
D-8000 MÜNCHEN 22

Telephon (089) 22 33 11
Telex 524282 FORBO D
Cables/Telegr. FORBOPAT MÜNCHEN
Telecopier
NEC4100(II&III automatic) (089) 22 15 69

| Our ref / Unser Zeichen | Your ref. / Ihr Zeichen | Date / Datum |
|---|---|---|
| FB 1933 | 87 115 932.3 | December 28, 1987 |

Dainippon Screen Mfg. Co., Ltd.

Referring to the official communication of December 15, 1987, it is respectfully requested to correct the application papers by replacing originally filed pages 22/23 by the enclosed new pages 22/23.

Reference is made to rule 88, i.e. the request for correction is based on the aforementioned rule. The expert, from the originally filed papers and particularly if considering same with the assistance of the priority document as originally filed, easily could see that pages 22/23 were negatively affected by a copying machine fault and that, within the scope of the original disclosure, supplementation

419

as by the enclosed new pages 22/23 has been possible.

Therefore, it is respectfully requested to conduct the correction asked for.

Dr. Goddar
Signed in his absence by

Dr. Hoormann

Encl.:

1 Copy of this amendment
New specification (claim)
pages 22 and 23, in trip.

BAD ORIGINAL